# EUROPEAN PATENT APPLICATION

(11) **EP 4 753 396 A1**
(43) Date of publication of application: **03.06.2026**
(21) Application number: 24865470.9
(22) Date of filing: 11.09.2024
(51) Int. Cl.: H10B 53/30, C04B 35/40, G11C 11/22

(54) **PULSED CURRENT DRIVE METHOD, PULSED CURRENT DRIVE STRUCTURE, CURRENT-DRIVEN MEMORY, STORAGE DEVICE, AND MEMORY CONTROL CIRCUIT**

(30) Priority: 13.09.2023 JP 2023148764
(71) Applicant: Sumitomo Chemical Company, Limited, Tokyo 103-6020 (JP); The University of Tokyo, Bunkyo-ku, Tokyo 113-8654 (JP)
(72) Inventor: OKAMOTO, Satoshi, Tokyo 103-6020 (JP); SAITOH, Eiji, Tokyo 113-8654 (JP); KIKKAWA, Takashi, Tokyo 113-8654 (JP); CHEN, Ziyan, Tokyo 113-8654 (JP)
(74) Representative: J A Kemp LLP
(86) International application number: PCT/JP2024/032498
(87) International publication number: WO 2025/057970

(57) **Abstract**

A pulsed current drive method inverts ferroelectric polarization generated by the order and imbalance of ions that have different valences by applying a pulsed current.

## Description

### Technical Field

The present disclosure relates to a pulsed current drive method, a pulsed current drive structure, a current-driven memory, a storage device, and a memory control circuit.

### Background Art

Conventionally, in electronic computers, storage devices called DRAM (Dynamic Random Access Memory) have been generally used. DRAM is composed of a capacitor and a transistor formed on a semiconductor substrate. DRAM stores one bit of data of "0" or "1" in two states by controlling the amount of electric charge accumulated in the capacitor with the transistor. In DRAM, the electric charge accumulated in the capacitor decreases over time. Therefore, in order to retain the stored data, refresh processing for recharging the capacitor at regular intervals is required.

Recently, so-called MRAM (Magnetoresistive Random Access Memory) has also been used. MRAM can store data for a long period of time without performing refresh processing like DRAM. In MRAM, a ferromagnetic tunnel junction element is formed by stacking a free magnetization layer that can be magnetized in a free direction and a fixed magnetization layer magnetized in a fixed direction. MRAM stores one bit of data of "0" or "1" in two states by means of this ferromagnetic tunnel junction element.

In the ferromagnetic tunnel junction element, the magnitude of electrical resistance differs between a case where the direction of magnetization of the free magnetization layer and the direction of magnetization of the fixed magnetization layer are in a parallel state and a case where they are in an antiparallel state. One bit of data is stored in two states utilizing these different states of electrical resistance (see Patent Literature 1). Therefore, in MRAM, data can be written by magnetizing the free magnetization layer in a predetermined direction.

### Citation List

### Patent Literature

[Patent Literature 1] Japanese Unexamined Patent Publication No. H11-097766
[Patent Literature 2] International Publication No. WO 2010/038786

### Summary of Invention

### Technical Problem

In DRAM, power is consumed along with refresh processing, so an increase in power consumption becomes a problem. In MRAM, the free magnetization layer is magnetized in a predetermined direction by causing a magnetic field of a threshold value or more to act on the free magnetization layer. In order to generate such a magnetic field based on Ampere's law, it is necessary to cause a relatively large current to flow. Therefore, even in MRAM, an increase in power consumption becomes a problem.

In contrast to this, a memory utilizing the dielectric characteristics of a compound having a layered triangular lattice structure containing a rare earth element has been proposed (see Patent Literature 2). According to this memory, power consumption can be reduced. However, this memory had a problem that it could not respond at high speed because it is driven by applying a voltage.

An object of the present disclosure is to provide a pulsed current drive method, a pulsed current drive structure, a current-driven memory, a storage device, and a memory control circuit that have low power consumption and are capable of responding at high speed.

### Solution to Problem

The present inventors have found that a memory having low power consumption and capable of responding at high speed can be provided by applying a current parallel to the c-axis direction (polarization axis direction or polar axis direction) of an electronic ferroelectric originating from electron transfer and reading out the voltage, and have arrived at the present invention.
[1] A pulsed current drive method for inverting ferroelectric polarization generated by the order and imbalance of ions having different valences by applying a pulsed current.
[2] A pulsed current drive structure in which ferroelectric polarization generated by the order and imbalance of ions having different valences is inverted by applying a pulsed current.
[3] A current-driven memory including:
   a pulsed current drive structure in which ferroelectric polarization generated by the order and imbalance of ions having different valences is inverted by applying a pulsed current; and
   electrodes provided on the pulsed current drive structure.
[4] The current-driven memory according to [3], further including at least one current source for applying a current between the electrodes.
[5] A storage device including:
   a memory cell including the current-driven memory according to [3] or [4];
   an output circuit for outputting a pulsed current for inverting the ferroelectric polarization of the memory cell; and
   an input circuit for receiving different nonlinear voltages generated depending on the state of ferroelectric polarization of the memory cell.
[6] A memory control circuit for controlling a current-driven memory including a pulsed current drive structure in which ferroelectric polarization generated by the order and imbalance of ions having different valences is inverted by applying a pulsed current, and electrodes provided on the pulsed current drive structure, the memory control circuit including:
   a pulsed current source for applying a pulsed current between the electrodes;
   an alternating current source for applying an alternating current between the electrodes;
   a voltage detection unit for detecting a voltage between the electrodes; and
   a control unit for controlling the pulsed current source to write data to the current-driven memory, and controlling the alternating current source and the voltage detection unit to read data from the current-driven memory.

### Advantageous Effects of Invention

According to one aspect of the present disclosure, a pulsed current drive method, a pulsed current drive structure, a current-driven memory, a storage device, and a memory control circuit that have low power consumption and are capable of responding at high speed are provided.

### Brief Description of Drawings

FIG. 1 is a schematic explanatory view of an arrangement of each element in a plan view of a compound having a layered triangular lattice structure.
FIG. 2 is a schematic explanatory view of an arrangement of each element in a side view of a compound having a layered triangular lattice structure.
FIG. 3 is a perspective view schematically showing a memory according to an embodiment.
FIG. 4 is a perspective view schematically showing the memory according to the embodiment.
FIG. 5 is a schematic diagram showing a storage device according to the embodiment.
FIG. 6 is a cross-sectional view schematically showing a memory according to a first modification.
FIG. 7 is a cross-sectional view schematically showing a memory according to a second modification.
FIG. 8 is a cross-sectional view schematically showing a memory according to a third modification.
FIG. 9 is a cross-sectional view schematically showing a memory according to a fourth modification.
FIG. 10 is a cross-sectional view schematically showing a memory according to a fifth modification.
FIG. 11 is a cross-sectional view schematically showing a memory according to a sixth modification.
FIG. 12 is a perspective view schematically showing a memory according to a seventh modification.
FIG. 13 is a perspective view for explaining a four-terminal measurement method.
FIG. 14 is a perspective view for explaining a two-terminal measurement method.
FIG. 15 is a graph showing results of measuring the nonlinear voltage of LuFe₂O₄ by a lock-in method.
FIG. 16 is a graph showing results of measuring the nonlinear voltage of LuFe₂O₄ by a lock-in method.
FIG. 17 is a process flow showing a method for manufacturing an element according to an example.
FIG. 18 is an XRD pattern of a laminated film produced in the example.
FIG. 19 is a RHEED pattern of a laminated film produced in the example.

### Description of Embodiments

Hereinafter, embodiments of the present disclosure will be described in detail with reference to the accompanying drawings. In the description of the drawings, the same or corresponding elements are denoted by the same reference numerals, and redundant description is omitted. In each drawing, an xyz orthogonal coordinate system is shown as necessary.

### (Electronic Ferroelectric)

An electronic ferroelectric used in the memory according to the present embodiment will be described. This electronic ferroelectric is not particularly limited as long as it is an electronic ferroelectric consisting only of arrangement and movement of electrons. An example of the electronic ferroelectric is composed of a compound having a layered triangular lattice structure containing a rare earth element, or the like. As such a compound, specifically, there is a compound having a layered triangular lattice structure represented by the general formula (RMbO3-δ)n(MaO)m, or a compound in which a part of R is substituted with an element having a positive divalent valence or less.

Here, R, Ma, Mb, n, m, and δ are as follows.
R: at least one element selected from Sc, Y, Dy, Ho, Er, Tm, Yb, Lu, Ca, Ce
Ma and Mb: at least one element selected from Ti, Mn, Fe, Co, Cu, Ga, Zn, Al, Mg, Cd, allowing duplication
n: an integer of 1 or more
m: an integer of 0 or more
δ: a real number of 0 or more and 0.2 or less

An element having a positive divalent valence or less is an element having a valence greater than 0 and +2 or less. Examples of elements having a positive divalent valence or less include Mg, Ca, Sr, Ba, Na, K, Rb, Cs, Sn, or Zn. The element having a positive divalent valence or less is preferably Ca, Sr, or Na. Since synthesis of the electronic ferroelectric is easy, the element having a positive divalent valence or less is more preferably Ca.

Hereinafter, a compound having a layered triangular lattice structure will be described with LuFe₂O₄, in which R is Lu and Ma and Mb are Fe, as a representative example.

LuFe₂O₄ is generated, for example, by the following procedure.
(1) Lutetium oxide (Lu₂O₃) and iron(III) oxide (Fe₂O₃) are mixed at a ratio of 1:2, and mixed in a ball mill for about 1 hour to generate a mixture.
(2) The mixture is molded into a predetermined shape and heated to 800°C for 24 hours in an oxygen atmosphere to generate a pre-fired body.
(3) The pre-fired body is finally fired by an FZ (Floating Zone) method to obtain single-crystal LuFe₂O₄. At this time, crystal growth is performed in an atmosphere of a CO-CO₂ mixed gas, which is a mixed gas of carbon monoxide and carbon dioxide.

In the final firing for generating a single crystal, a CO₂-H₂ mixed gas may be used instead of the CO-CO₂ mixed gas. The amount of oxygen is adjusted by firing while controlling the oxygen partial pressure in a reducing atmosphere.

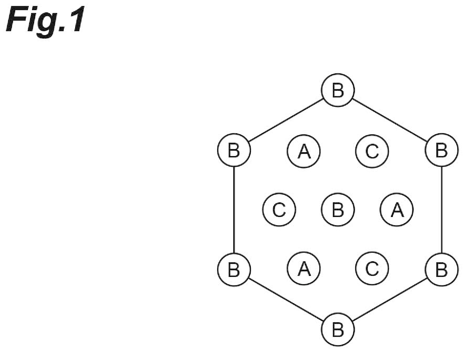

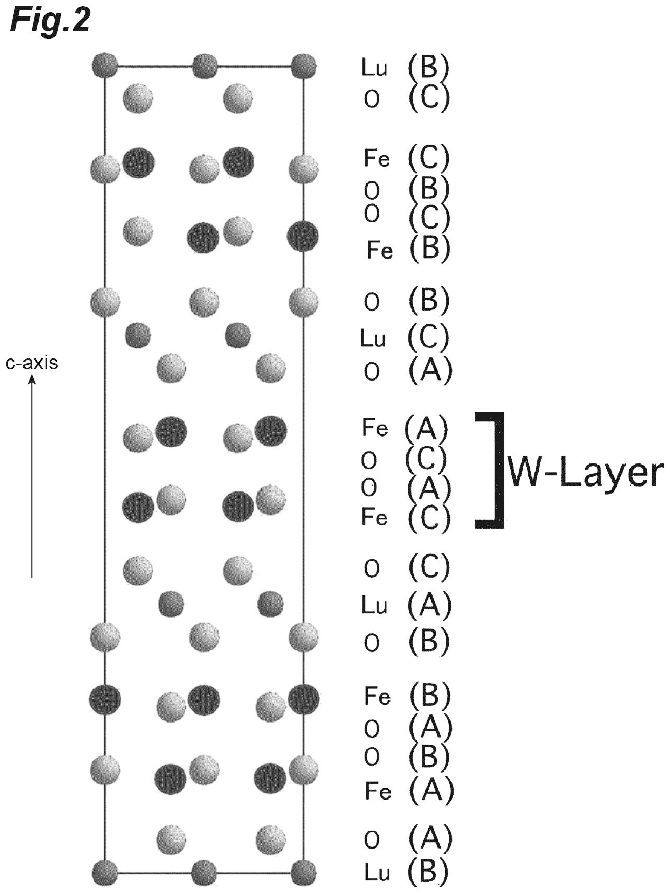

The crystal structure of single-crystal LuFe₂O₄ will be described with reference to FIGS. 1 and 2. For convenience of explanation, the crystal structure of LuFe₂O₄ is shown in a state before so-called charge ordering, in which a regular structure of Fe³⁺ and Fe₂+ does not appear in Fe ions in the crystal.

FIG. 1 is a schematic explanatory view of an arrangement of each element in a plan view. FIG. 1 shows a positional relationship among a triangular lattice of element A, a triangular lattice of element B, and a triangular lattice of element C. Hereinafter, the position of a lattice point in the triangular lattice of element A will be referred to as "A position," the position of a lattice point in the triangular lattice of element B will be referred to as "B position," and the position of a lattice point in the triangular lattice of element C will be referred to as "C position."

FIG. 2 is a schematic explanatory view of an arrangement of each element in a side view. In FIG. 2, along the c-axis direction downward from the uppermost layer, each element is positioned at a predetermined position in the following order.
Lu - B position
O - C position
Fe - C position
O - B position
O - C position
Fe - B position
O - B position
Lu - C position
O - A position
Fe - A position *
O - C position *
O - A position *
Fe - C position *
O - C position
Lu - A position
O - B position
Fe - B position
O - A position
O - B position
Fe - A position
O - A position
Lu - B position

Among these, a portion composed of four layers marked with asterisks is called a W layer (W-Layer). Having this W layer is a characteristic of LuFe₂O₄. It is known that a W layer is similarly formed in compounds having a layered triangular lattice structure other than LuFe₂O₄. The W layer has a stacked structure of triangular lattices, and causes charge frustration by allowing the same number of Fe²⁺ and Fe³⁺ to exist in LuFe₂O₄.

As a result, in LuFe₂O₄, a region rich in Fe³⁺ in the W layer acts as a positive charge, and a region rich in Fe²⁺ acts as a negative charge. As a result, an electric dipole (electric polarization) appears in the W layer that is directed from the region rich in Fe²⁺ to the region rich in Fe³⁺. That is, LuFe₂O₄ exhibits ferroelectric polarization due to the order and imbalance of iron ions having different valences. The polarization axis direction or polar axis of the W layer is parallel to the c-axis direction of the crystal. In LuFe₂O₄, the state of the electric dipole can be controlled by applying a current from the outside. LuFe₂O₄ exhibits different nonlinear voltages depending on the state of this electric dipole. In LuFe₂O₄, ferroelectric polarization generated by the order and imbalance of ions having different valences can be inverted, for example, by applying a pulsed current from the outside. "Order and imbalance of ions having different valences" is generated by the coexistence of a region rich in Fe²⁺ and a region rich in Fe³⁺ in the W layer, as described above.

Note that in LuFe₂O₄ (space group: Cm), polarization is generated by an imbalance of two iron ions, Fe²⁺ and Fe³⁺, in the W layer composed of a stacked structure of triangular lattices, but the crystal structure and ion species are not limited thereto. Examples include the following. (LaCa)Mn₂O₆ and (PrCa)Mn₂O₆ (charge ordering of Mn³⁺ and Mn⁴⁺, space group: P2₁/m), TbBaMn₂O₆ and YBaMn₂O₆ (charge ordering of Mn³⁺ and Mn⁴⁺, space group: P-1 (where "-1" indicates 1 with an overline)), (LaSr₂)Mn₂O₇ (charge ordering of Mn³⁺ and Mn⁴⁺, space group: Bbmm), LiMn₂O₄ (charge ordering of Mn³⁺ and Mn⁴⁺, space group: Fddd), TbBaFe₂O₅ (charge ordering of Fe²⁺ and Fe³⁺, space group: Pmma), Ca₂Fe₂O₆ (charge ordering of Fe³⁺ and Fe⁵⁺, space group: P2₁/n), YBaCo₂O₅ (charge ordering of Co²⁺ and Co³⁺, space group: Pmma), Y₂Ni₂O₆ (charge ordering of Ni²⁺ and Ni⁴⁺, space group: P2₁/n), Ba₃NaRu₂O₉ (charge ordering of Ru⁵⁺ and Ru⁶⁺, space group: P2/c), bilayer graphene (charge ordering by interlayer charge transfer).

Thus, a compound having a layered triangular lattice structure containing a rare earth element has a W layer, and can control the charge ordering structure in the W layer by a current applied from the outside to generate different nonlinear voltage states (nonlinear voltage state control method). In other words, this compound exhibits different values of nonlinear voltage depending on the direction of polar ordering that can be controlled by current. The polar ordering is maintained in the same direction even after the current is turned off, and has non-volatility. Therefore, a non-volatile memory (non-volatile binary memory) can be configured with this compound. The film 2 described later is a nonlinear voltage state generating structure capable of generating different nonlinear voltage states by controlling the charge ordering structure in the W layer of the compound having a layered triangular lattice structure containing a rare earth element by a current applied from the outside.

### (Memory)

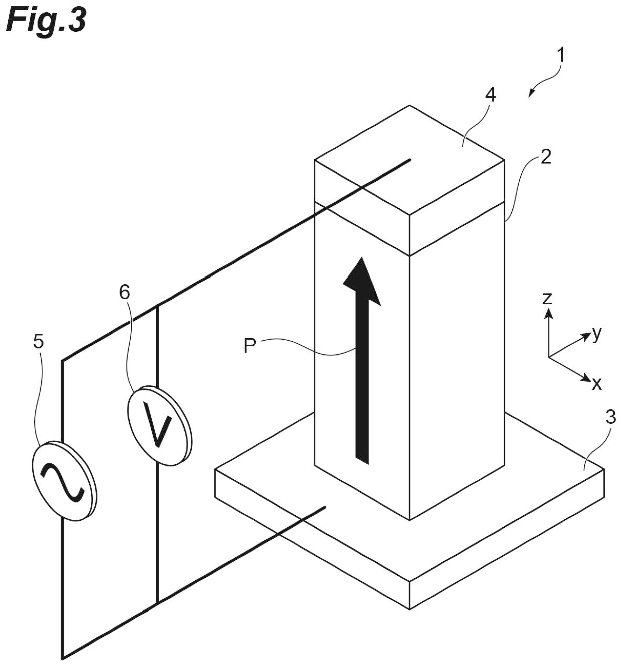

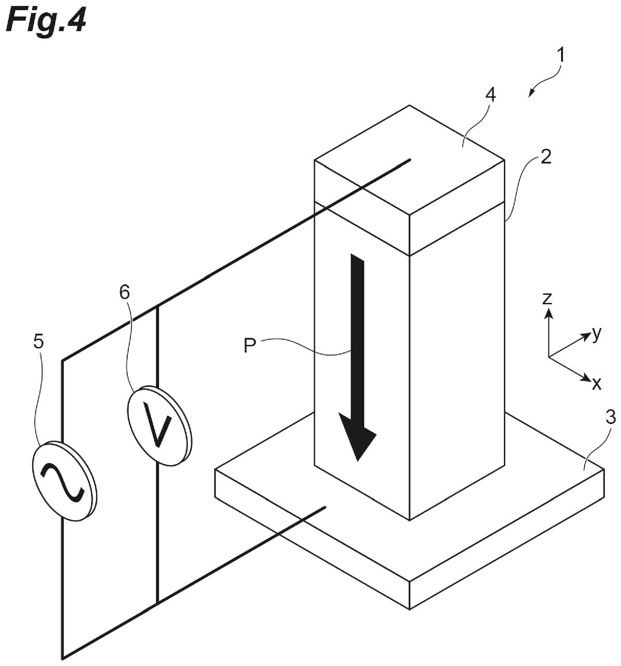

A memory according to the present embodiment will be described. FIGS. 3 and 4 are perspective views schematically showing the memory according to the present embodiment. As shown in FIGS. 3 and 4, the memory 1 according to the present embodiment includes a film 2 (pulsed current drive structure), a first electrode 3, a second electrode 4, a current source 5, and a voltage detection unit 6. The memory 1 is a current-driven memory.

The film 2 includes the above-described electronic ferroelectric having a crystal structure in which layers in which electric polarization is generated in the c-axis direction of the crystal are stacked. The film 2 is formed such that the c-axis direction of the crystal is parallel to the z direction. In FIGS. 3 and 4, the film 2 is shown in a rectangular parallelepiped shape having the z direction as the longitudinal direction, but may be a LuFe₂O₄ thin film having the z direction as the thickness direction. The electronic ferroelectric constituting the film 2 is preferably a single crystal of LuFe₂O₄, but may be polycrystalline.

FIG. 3 shows a state in which the polar ordering P of the film 2 is in the +z direction. That is, in the W layer of the film 2, as a result of Fe²⁺ becoming abundant on the first electrode 3 side and Fe³⁺ becoming abundant on the second electrode 4 side, an electric dipole oriented in the +z direction appears. FIG. 4 shows a state in which the polar ordering P of the film 2 is in the -z direction. That is, in the W layer of the film 2, as a result of Fe³⁺ becoming abundant on the first electrode 3 side and Fe²⁺ becoming abundant on the second electrode 4 side, an electric dipole oriented in the -z direction appears.

The first electrode 3 and the second electrode 4 are provided on the film 2 so as to be separated from each other in the c-axis direction. The first electrode 3 and the second electrode 4 are provided at both ends of the film 2 in the z direction so as to sandwich the film 2 in the z direction. The first electrode 3 and the second electrode 4 face each other in the z direction with the film 2 interposed therebetween. The first electrode 3, the film 2, and the second electrode 4 are stacked in this order. The first electrode 3 constitutes a lower electrode. The first electrode 3 is a conductive substrate. The first electrode 3 may be a conductive thin film. The second electrode 4 constitutes an upper electrode. The second electrode 4 is a conductive thin film. The first electrode 3 and the second electrode 4 are composed of, for example, a highly conductive metal such as Ag or Cu.

The current source 5 is a device for applying a current between the first electrode 3 and the second electrode 4. The current source 5 is connected to the first electrode 3 and the second electrode 4. The current source 5 includes a pulsed current source and an alternating current source. That is, the current source 5 functions as a pulsed current source and also functions as an alternating current source. The pulsed current source applies a pulsed current used for data writing between the first electrode 3 and the second electrode 4. The pulsed current source applies a pulsed current one pulse at a time between the first electrode 3 and the second electrode 4 each time data is written.

Here, a pulsed current is, for example, a rectangular waveform-shaped direct current having a width of 100 msec or less. The intensity of the pulsed current is typically about one order of magnitude larger than the amplitude of the alternating current. The intensity of the pulsed current may be, for example, 2 times or more, 5 times or more, or 10 times or more the amplitude of the alternating current. The direction of the pulsed current is a direction from the first electrode 3 toward the second electrode 4, or a direction from the second electrode 4 toward the first electrode 3.

The alternating current source applies an alternating current used for data reading between the first electrode 3 and the second electrode 4. The current source 5 writes data to the film 2 by applying a pulsed current between the first electrode 3 and the second electrode 4. Although the current source 5 of the present embodiment is one device that serves both as a pulsed current source and an alternating current source, the pulsed current source and the alternating current source may be separate devices. That is, the current source 5 consists of at least one current source (device).

The voltage detection unit 6 is used for data reading. The voltage detection unit 6 detects a voltage between two points separated from each other in the c-axis direction in the film 2. The voltage detected is a nonlinear voltage. In the present embodiment, the voltage detection unit 6 is connected to the first electrode 3 and the second electrode 4. The voltage detection unit 6 is connected to the first electrode 3 and the second electrode 4 in parallel with the current source 5. The voltage detection unit 6 is, for example, a lock-in device, and reads the voltage between the first electrode 3 and the second electrode 4.

An example of a method for manufacturing the memory 1 will be described. First, a first electrode 3 made of a conductive substrate is prepared, and a film 2 is formed on the first electrode 3. The film 2 is, for example, a single-crystal film or polycrystalline film that is epitaxially grown on the surface of the first electrode 3 by a CVD (Chemical Vapor Deposition) method, a sputtering method, an MBE (Molecular Beam Epitaxy) method, an aerosol deposition method, or the like, using LuFe₂O₄ in the form of fine particles. The film 2 becomes a single-crystal film by epitaxial growth, but becomes a polycrystalline film depending on film formation conditions such as crystallization rate. LuFe₂O₄ in the form of fine particles is obtained, for example, by pulverizing single-crystal LuFe₂O₄ generated by the above-described procedure.

Subsequently, a second electrode 4 is formed on the film 2. The second electrode 4 is formed, for example, by applying Ag paste to the surface of the film 2. The second electrode 4 may be formed by a sputtering method or the like. Here, an etching mask may be formed on the upper surface of the second electrode 4, and the second electrode 4 and the film 2 may be sequentially etched by etching or electron beam lithography to make the second electrode 4 and the film 2 have a desired shape. Finally, the memory 1 is obtained by connecting the current source 5 and the voltage detection unit 6 to the first electrode 3 and the second electrode 4.

When forming the film 2, the c-axis direction of LuFe₂O₄ is made to coincide with the facing direction (z direction) of the first electrode 3 and the second electrode 4 in the crystal growth process on the substrate surface. Here, by using a substrate whose crystal plane of the surface is adjusted as the conductive substrate constituting the first electrode 3, the c-axis direction of LuFe₂O₄ is made to coincide with the z direction. Note that the c-axis direction of LuFe₂O₄ does not necessarily have to completely coincide with the facing direction of the first electrode 3 and the second electrode 4. It is sufficient that at least the c-axis direction of LuFe₂O₄ is not orthogonal to the facing direction of the first electrode 3 and the second electrode 4. As a result, a current component parallel to the c-axis direction can be applied to the film 2 using the current source 5.

The driving method of the memory 1 includes a writing step and a reading step. The writing step is a step of writing data to the film 2 by applying a pulsed current parallel to the c-axis direction to the film 2. Specifically, a pulsed current is applied to the film 2 by applying a pulsed current between the first electrode 3 and the second electrode 4 using the current source 5. The writing step is a step using a pulsed current drive method for inverting ferroelectric polarization generated by the order and imbalance of ions having different valences by applying a pulsed current.

The reading step is a step of reading data from the film 2 by detecting a nonlinear voltage between two points separated from each other in the c-axis direction while applying an alternating current parallel to the c-axis direction to the film 2. Specifically, while applying an alternating current between the first electrode 3 and the second electrode 4 using the current source 5, a nonlinear voltage between the first electrode 3 and the second electrode 4 is detected using the voltage detection unit 6.

As described above, since a compound having a layered triangular lattice structure containing a rare earth element is used for the electronic ferroelectric, the memory 1 as a binary memory that has low power consumption and can respond at high speed is obtained.

### (Storage Device)

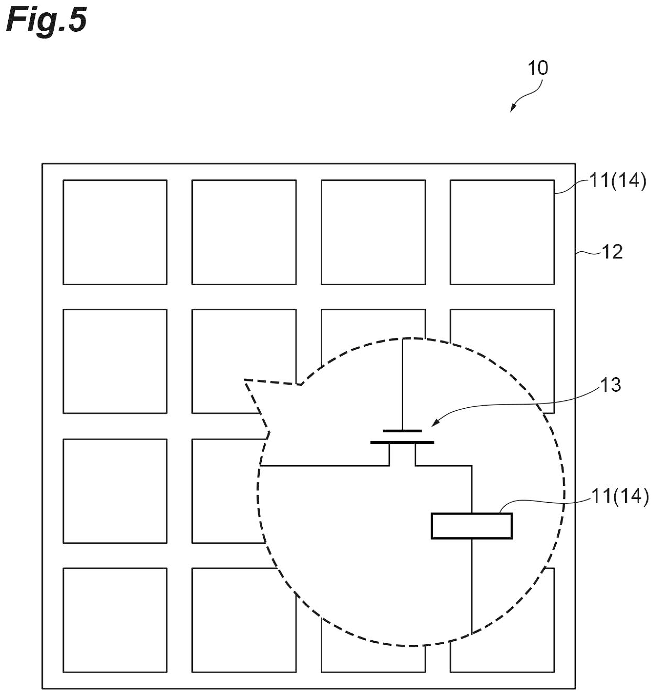

A storage device according to the present embodiment will be described. FIG. 5 is a schematic diagram showing the storage device according to the embodiment. As shown in FIG. 5, the storage device 10 according to the present embodiment includes at least one memory cell 11. The storage device 10 includes a plurality of memory cells 11. In the illustrated example, the plurality of memory cells 11 are arranged on an insulating substrate 12 in four vertical columns and four horizontal columns so as to be separated from each other. Each memory cell 11 includes a film 2, a first electrode 3, and a second electrode 4, similarly to the memory 1. Each memory cell 11 comprises the memory 1. The insulating substrate 12 is formed of, for example, ScAlMgO₄.

In the memory cell 11, the first electrode 3 is composed of a conductive thin film and is formed so as to be separated from each other on a corresponding rectangular region of the insulating substrate 12. The plurality of films 2 are formed so as to be separated from each other on the corresponding first electrodes 3. The plurality of second electrodes 4 are formed so as to be separated from each other on the corresponding films 2. The first electrodes 3 of the plurality of memory cells 11 may be composed of a single continuous conductive substrate. In this case, the storage device 10 may not include the insulating substrate 12.

Although not shown in the drawing, the storage device 10 includes a current source 5 (output circuit) and a voltage detection unit 6 (input circuit) (see FIG. 3), similarly to the memory 1. The plurality of memory cells 11 are connected in parallel to one common current source 5. The current source 5 is connected to the first electrode 3 of each memory cell 11 and is connected to the second electrode 4 of each memory cell 11 via a corresponding transistor 13. The transistor 13 may be connected between the current source 5 and the first electrode 3, not between the current source 5 and the second electrode 4. The current source 5 functions as a pulsed current source as described above, and outputs a pulsed current for inverting the ferroelectric polarization of the memory cell 11. The current source 5 can be said to be a pulsed current source for data writing of current-driven memory cells.

The plurality of memory cells 11 are also connected in parallel to one common voltage detection unit 6. The voltage detection unit 6 is connected to the first electrode 3 of each memory cell 11 and is connected to the second electrode 4 of each memory cell 11 via a corresponding transistor 13. The transistor 13 may be connected between the voltage detection unit 6 and the first electrode 3, not between the voltage detection unit 6 and the second electrode 4. The voltage detection unit 6 receives different nonlinear voltages generated depending on the state of ferroelectric polarization of the memory cell 11. The voltage detection unit 6 can be said to be a circuit for detecting nonlinear voltage of current-driven memory cells. The voltage detection unit 6 may be a circuit connected to an electrode common with the current source 5 (a configuration corresponding to the two-terminal measurement method described later), or may be a circuit connected to an electrode different from the current source 5 (a configuration corresponding to the four-terminal measurement method described later).

The gate of the transistor 13 is connected to a control unit (not shown). The on/off of the transistor 13 is controlled by a control signal output from this control unit. As a result, data can be written to the film 2 by applying a pulsed current to a desired memory cell 11, and data of the film 2 can be read by applying an alternating current to a desired memory cell 11. It can be said that the storage device 10 includes at least one memory 14 including a memory cell 11, a current source 5, and a voltage detection unit 6.

Thus, the storage device 10 uses the above-described electronic ferroelectric and includes at least one memory 14 that is current-driven, so it has low power consumption and can respond at high speed. In the storage device 10, high density can be achieved by miniaturizing the film 2.

In the storage device 10, the current source 5 (pulsed current source and alternating current source), the voltage detection unit 6, and the control unit can be said to be a memory control circuit for controlling the memory cell 11 (current-driven memory). The control unit writes data to the memory cell 11 by controlling the current source 5 to apply a pulsed current between the first electrode 3 and the second electrode 4. It can be said that the control unit reads data from the memory cell 11 by controlling the current source 5 and the voltage detection unit 6 to apply an alternating current between the first electrode 3 and the second electrode 4.

The input/output method of the storage device 10 includes a pulsed current output step of outputting a pulsed current for inverting the ferroelectric polarization of the memory cell 11, and a nonlinear voltage input step of inputting different nonlinear voltages generated depending on the state of ferroelectric polarization of the memory cell 11. The input/output device of the storage device 10 is configured to include a current source 5 (output circuit) that outputs a pulsed current for inverting the ferroelectric polarization of the memory cell 11, and a voltage detection unit 6 (input circuit) that inputs different nonlinear voltages generated depending on the state of ferroelectric polarization of the memory cell 11. The current source 5 and the voltage detection unit 6 are connected to a common wiring. In the control method of the storage device 10, individual data is written to the film 2 via the second electrode 4 with the first electrode 3 at a common potential.

An example of a method for manufacturing the storage device 10 will be described. First, an insulating substrate 12 is prepared, and a first continuous electrode to be a plurality of first electrodes 3 is formed on the insulating substrate 12. The first continuous electrode is formed, for example, by applying Ag paste to the surface of the insulating substrate 12. The first continuous electrode may be formed by a sputtering method or the like.

Subsequently, a continuous film to be a plurality of films 2 is formed on the first continuous electrode. The continuous film is formed on the surface of the first continuous electrode by, for example, a CVD method, a sputtering method, an MBE method, or an aerosol deposition method, using LuFe₂O₄ in the form of fine particles.

Subsequently, a second continuous electrode to be a plurality of second electrodes 4 is formed on the continuous film. The second continuous electrode is formed, for example, by applying Ag paste to the surface of the continuous film. The second continuous electrode may be formed by a sputtering method or the like.

Subsequently, an etching mask is formed on the upper surface of the second continuous electrode, and the second continuous electrode, the continuous film, and the first continuous electrode are sequentially etched by etching or electron beam lithography. As a result, a plurality of memory cells 11 are formed. Finally, the storage device 10 is obtained by connecting the current source 5 and the voltage detection unit 6 to the first electrode 3 and the second electrode 4.

### (Modifications)

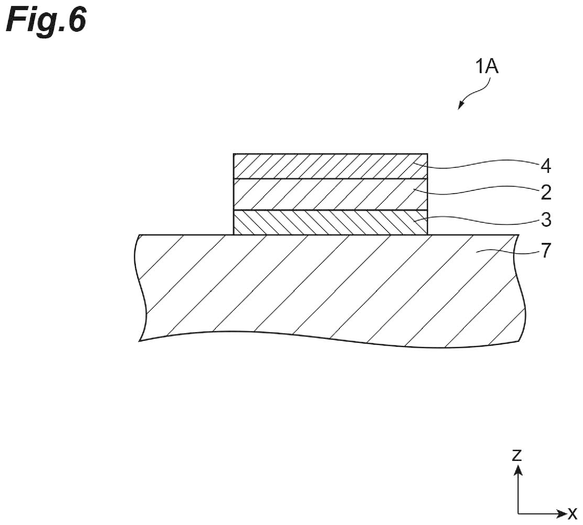

Modifications of the memory 1 will be described with reference to FIGS. 6 to 12. In FIGS. 6 to 11, the illustration of the current source 5 and the voltage detection unit 6 is omitted.

FIG. 6 is a cross-sectional view schematically showing a memory according to a first modification. As shown in FIG. 6, a memory 1A according to the first modification differs from the memory 1 in that the first electrode 3 is composed of a conductive thin film and is formed on an insulating substrate 7. The insulating substrate 7 is formed of, for example, ScAlMgO₄.

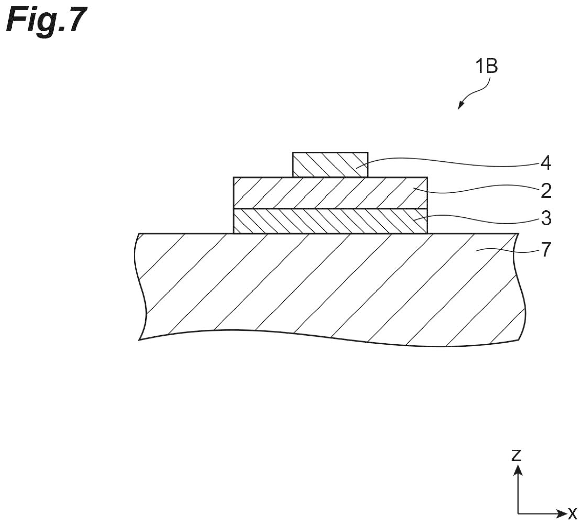

FIG. 7 is a cross-sectional view schematically showing a memory according to a second modification. As shown in FIG. 7, a memory 1B according to the second modification differs from the memory 1A in the width dimension (length in the x direction) of the second electrode 4. The second electrode 4 of the memory 1A has the same width dimension as the first electrode 3 and the film 2, and covers the entire upper surface of the film 2. In contrast, the second electrode 4 of the memory 1B has a width dimension smaller than the film 2, and exposes a part of the upper surface of the film 2. In the memory 1B, the length of the second electrode 4 in the y direction may be the same as the length of the first electrode 3 and the film 2 in the y direction, or may be shorter.

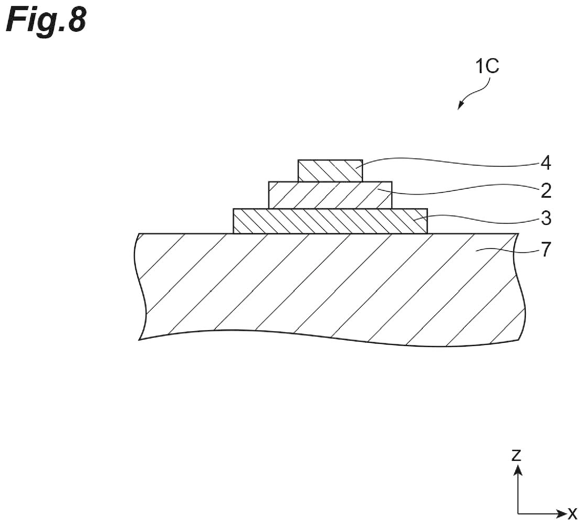

FIG. 8 is a cross-sectional view schematically showing a memory according to a third modification. As shown in FIG. 8, a memory 1C according to the third modification differs from the memory 1A not only in the width dimension (length in the x direction) of the second electrode 4 but also in the width dimension of the film 2. The second electrode 4 of the memory 1C has a width dimension smaller than the film 2, similarly to the second electrode 4 of the memory 1B, and exposes a part of the upper surface of the film 2. The film 2 of the memory 1B has the same width dimension as the first electrode 3, and covers the entire upper surface of the first electrode 3. In contrast, the second electrode 4 of the memory 1C has a width dimension smaller than the first electrode 3, and exposes a part of the upper surface of the first electrode 3. In the memory 1C, the length of the second electrode 4 in the y direction may be the same as the length of the film 2 in the y direction, or may be shorter. The length of the film 2 in the y direction may be the same as the length of the first electrode 3 in the y direction, or may be shorter.

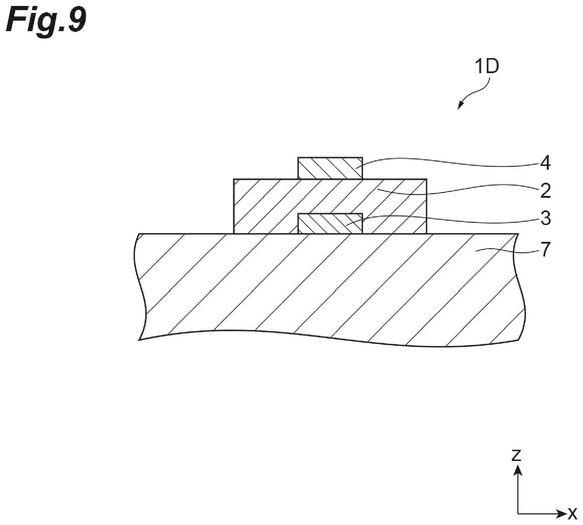

FIG. 9 is a cross-sectional view schematically showing a memory according to a fourth modification. As shown in FIG. 9, a memory 1D according to the fourth modification differs from the memory 1A in that the width dimensions (lengths in the x direction) of the first electrode 3 and the second electrode 4 are smaller than the width dimension of the film 2. The film 2 of the memory 1D covers the upper surface and side surfaces of the first electrode 3. In the memory 1D, the lengths of the first electrode 3 and the second electrode 4 in the y direction may be the same as the length of the film 2 in the y direction, or may be shorter. In the memory 1D, the c-axis direction of the crystal of the film 2 can be made the z direction by forming the film 2 using the first electrode 3 and the insulating substrate 7 whose crystal planes of the surfaces are adjusted.

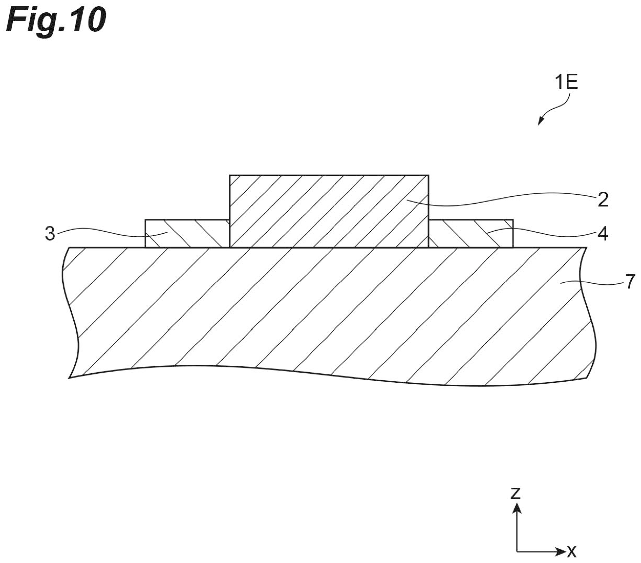

FIG. 10 is a cross-sectional view schematically showing a memory according to a fifth modification. As shown in FIG. 10, a memory 1E according to the fifth modification differs from the memory 1A in that the first electrode 3 and the second electrode 4 are formed so as to be separated in the x direction, not in the z direction. In the memory 1E, the first electrode 3, the film 2, and the second electrode 4 are arranged in this order in the x direction on the insulating substrate 7. The film 2 is formed such that the c-axis direction of the crystal is parallel to the x direction.

An example of a method for manufacturing the memory 1E will be described. First, an insulating substrate 7 is prepared, and a film 2 is formed on the insulating substrate 7. The film 2 is formed on the surface of the insulating substrate 7 by, for example, a CVD (Chemical Vapor Deposition) method, a sputtering method, an MBE (Molecular Beam Epitaxy) method, or an aerosol deposition method, using LuFe₂O₄ in the form of fine particles. The film 2 may be further formed into a desired cell shape by electron beam lithography or the like.

Subsequently, a metal layer is formed on the insulating substrate 7 by a sputtering method or the like to cover the film 2. Thereafter, an etching mask is formed on the metal layer, and the metal layer is etched to form the first electrode 3 and the second electrode 4 on both sides of the film 2 in the x direction. Finally, the memory 1E is obtained by connecting the current source 5 and the voltage detection unit 6 to the first electrode 3 and the second electrode 4.

Instead of forming the film 2 before the first electrode 3 and the second electrode 4, the first electrode 3 and the second electrode 4 may be formed before the film 2. The c-axis direction of the crystal of the film 2 can be made the x direction by forming the film 2 using the insulating substrate 7 whose crystal plane of the surface is adjusted.

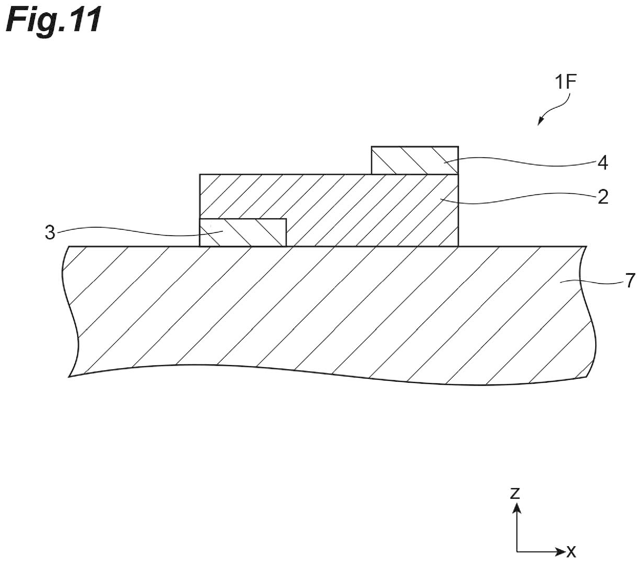

FIG. 11 is a cross-sectional view schematically showing a memory according to a sixth modification. As shown in FIG. 11, a memory 1F according to the sixth modification differs from the memory 1D in the arrangement of the first electrode 3 and the second electrode 4. In the memory 1D, since the first electrode 3 and the second electrode 4 are arranged at the same position in the x direction, the c-axis direction of the crystal of the film 2 completely coincides with the facing direction of the first electrode 3 and the second electrode 4.

In contrast, in the memory 1F, since the first electrode 3 and the second electrode 4 are arranged at different positions in the x direction, the c-axis direction of the crystal of the film 2 does not completely coincide with the facing direction of the first electrode 3 and the second electrode 4. The c-axis direction of the crystal of the film 2 is not orthogonal to the facing direction of the first electrode 3 and the second electrode 4. Therefore, a current component parallel to the c-axis direction can be applied to the film 2 by the current source 5. In the memory 1F, similarly to the memory 1D, the c-axis direction of the crystal of the film 2 can be made the z direction by forming the film 2 using the first electrode 3 and the insulating substrate 7 whose crystal planes of the surfaces are adjusted.

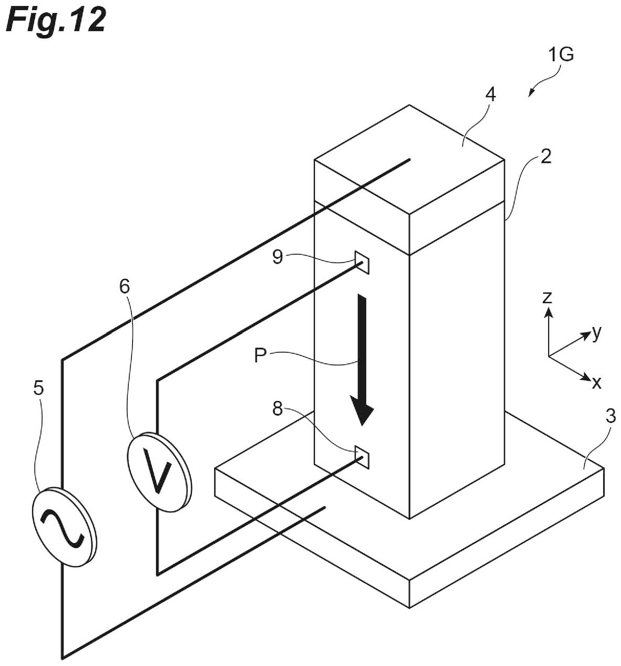

FIG. 12 is a perspective view schematically showing a memory according to a seventh modification. As shown in FIG. 12, a memory 1G according to the seventh modification differs from the memory 1 in that it further includes a third electrode 8 and a fourth electrode 9. The first electrode 3 and the second electrode 4 of the memory 1 are electrodes used for both current application and voltage detection. In contrast, in the memory 1G, the first electrode 3 and the second electrode 4 are electrodes for current application, and the third electrode 8 and the fourth electrode 9 are electrodes for voltage detection.

The third electrode 8 and the fourth electrode 9 are provided on the film 2 so as to be separated from each other in the c-axis direction. The third electrode 8 and the fourth electrode 9 are provided on one side surface of the film 2 extending in the c-axis direction. Also in the memory 1G, a current parallel to the c-axis direction can be applied to the film 2 by the current source 5, and the voltage applied to the film 2 can be detected by the voltage detection unit 6.

Also in the memories 1A, 1B, 1C, 1D, 1E, 1F, and 1G according to the above modifications, since they are current-driven using the above-described electronic ferroelectric, they have low power consumption and are capable of high-speed response.

The present invention is not necessarily limited to the above-described embodiment and the above modifications, and various modifications are possible without departing from the gist thereof. For example, the above embodiment and the above modifications may be combined as appropriate.

### [Examples]

Hereinafter, the present invention will be described by showing examples, but the present invention is not limited to the following examples.

A demonstration experiment of data writing and reading to/from LuFe₂O₄ was performed. Data writing and reading can be performed by either a four-terminal measurement method or a two-terminal measurement method.

### (Four-Terminal Measurement Method)

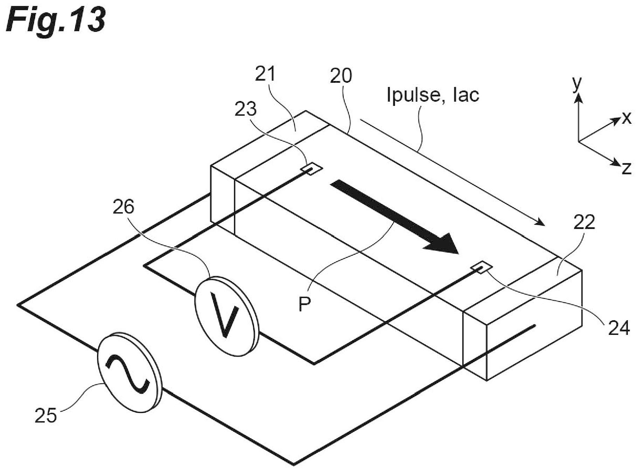

FIG. 13 is a perspective view for explaining the four-terminal measurement method. In the four-terminal measurement method, four electrodes are provided on a sample 20, similarly to the memory 1G of the seventh modification. A first electrode 21 and a second electrode 22 are electrodes for current application, and are provided at both ends of the sample 20 in the c-axis direction (polarization axis direction or polar axis). A third electrode 23 and a fourth electrode 24 are electrodes for voltage detection, and are provided on one side surface of the sample 20 extending in the c-axis direction.

The third electrode 23 and the fourth electrode 24 are provided at positions separated from each other in the c-axis direction and also separated from the first electrode 21 and the second electrode 22. The first electrode 21 and the second electrode 22 are connected to a current source 25, and the third electrode 23 and the fourth electrode 24 are connected to a voltage detection unit 26. The current source 25 and the voltage detection unit 26 have configurations equivalent to the current source 5 and the voltage detection unit 6 of the memory 1 according to the embodiment.

In the four-terminal measurement method, as an input to the sample 20, the current source 25 causes a pulsed current for writing Iₚᵤₗₛₑ and an alternating current for reading I_{ac} = (√2)Iᵣₘₛ sin(ωt) to flow parallel to the c-axis direction in the sample 20. Here, ω is an angular frequency (the corresponding frequency is f = ω/2π), t is time, and Iᵣₘₛ represents an effective value of the alternating current. The polar ordering P changes due to the pulsed current for writing Iₚᵤₗₛₑ, and the change is output to the voltage detection unit 26 as a nonlinear voltage V_{2ω,y} corresponding to twice the frequency of the alternating current for reading I_{ac} = (√2)Iᵣₘₛ sin(ωt). The nonlinear voltage V_{2ω,y} corresponding to twice the frequency of the alternating current for reading I_{ac} is the y component of the second harmonic (2ω) lock-in voltage.

### (Two-Terminal Measurement Method)

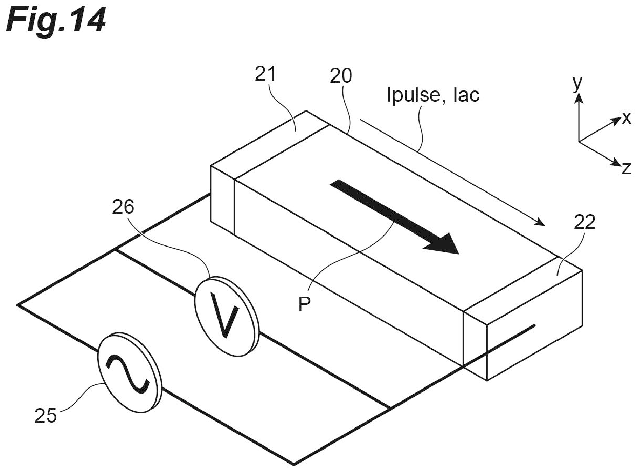

FIG. 14 is a perspective view for explaining the two-terminal measurement method. In the two-terminal measurement method, two electrodes are provided on the sample 20, similarly to the memory 1 of the embodiment. In the two-terminal measurement method, a first electrode 21 and a second electrode 22 provided at both ends of the sample 20 in the c-axis direction are used. The first electrode 21 and the second electrode 22 are electrodes for current application and for voltage detection, similarly to the first electrode 3 and the second electrode 4 of the memory 1 according to the embodiment, and the current source 25 and the voltage detection unit 26 are connected in parallel. Also in the two-terminal measurement method, the pulsed current for writing Iₚᵤₗₛₑ and the alternating current for reading I_{ac} are flowed through the sample 20 by the current source 25, and the nonlinear voltage V_{2ω,y} is detected by the voltage detection unit 26.

### (Demonstration Experiment 1)

As demonstration experiment 1, a demonstration experiment of data writing and reading was performed using the four-terminal measurement method. First, single-crystal LuFe₂O₄ was generated by the above-described procedure and used as a sample. Four electrodes were formed by applying Ag paste to a predetermined portion of the sample. A current source device (Keithley Model 6221) was connected to the first electrode and the second electrode as a current source. A lock-in device (LI5650 manufactured by NF Corporation) was connected to the third electrode and the fourth electrode as a voltage detection unit.

Next, after changing a pulsed current Iₚᵤₗₛₑ having a pulse width of 80 msec from 2 mA to -2 mA at intervals of 40 µA, the pulsed current Iₚᵤₗₛₑ was changed in the reverse direction from -2 mA to 2 mA at intervals of 40 µA. The change in polar ordering due to this pulsed current was detected by the lock-in method as a nonlinear voltage V_{2ω,y} corresponding to twice the frequency of the alternating current for reading I_{ac} = (√2)Iᵣₘₛ sin(ωt).

Here, f = ω/2π = 77.423 Hz, |I_{ac}| = 50 µA, Iᵣₘₛ = 35.36 µA. The conditions of the lock-in device were Dynamic reserve = MED, Sensitivity = 50 mV, Time constant = 1 s, SLOPE = -24 dB. The measurement was performed in a room temperature and zero magnetic field environment. The pulsed current Iₚᵤₗₛₑ and the alternating current Iac were flowed parallel to the c-axis direction of the sample.

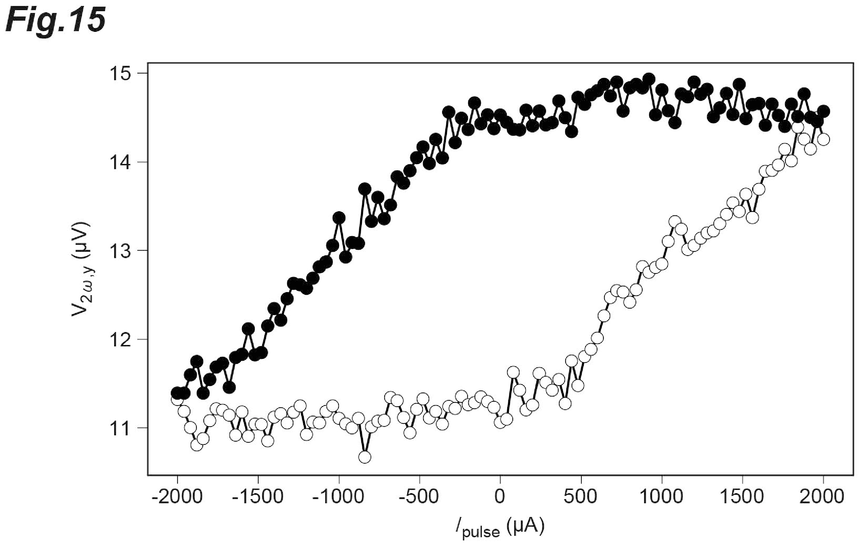

FIG. 15 is a graph showing results of measuring the nonlinear voltage of LuFe₂O₄ by the lock-in method. The horizontal axis shows the pulsed current Iₚᵤₗₛₑ (µA), and the vertical axis shows the y component V_{2ω,y} of the second harmonic (2ω) lock-in voltage. In FIG. 15, the measurement points when the pulsed current Iₚᵤₗₛₑ is changed from 2 mA to -2 mA are shown in dark color, and the measurement points when the pulsed current Iₚᵤₗₛₑ is changed from -2 mA to 2 mA are shown in light color. As shown in FIG. 15, a hysteresis curve of the nonlinear voltage was obtained. From this result, it was confirmed that the nonlinear voltage of LuFe₂O₄ can be read by alternating current and pulsed current driving at room temperature.

### (Demonstration Experiment 2)

As demonstration experiment 2, a demonstration experiment of non-volatile memory response was performed using the four-terminal measurement method. First, a sample was prepared in the same manner as in demonstration experiment 1, and a current source and a voltage detection unit were connected. Next, a pulsed current Iₚᵤₗₛₑ having a pulse width of 80 msec was applied at -2 mA, and after a waiting time of 45 seconds, the first data was acquired by measuring the y component V_{2ω,y} of the second harmonic lock-in voltage. Thereafter, five additional data points were acquired without a waiting time. Subsequently, a pulsed current Iₚᵤₗₛₑ having a pulse width of 80 msec was applied at +2 mA, and after a waiting time of 45 seconds, the first data was acquired by measuring the y component V_{2ω,y} of the second harmonic lock-in voltage. Thereafter, five additional data points were acquired without a waiting time. This procedure was then repeated..

Here, f = ω/2π = 13.423 Hz, |I_{ac}| = 50 µA, Iᵣₘₛ = 35.36 µA. The conditions of the lock-in device were Dynamic reserve = MED, Sensitivity = 50 mV, Time constant = 1 s, SLOPE = -24 dB. The measurement was performed in a room temperature and zero magnetic field environment. The pulsed current Iₚᵤₗₛₑ and the alternating current I_{ac} were flowed parallel to the c-axis direction of the sample.

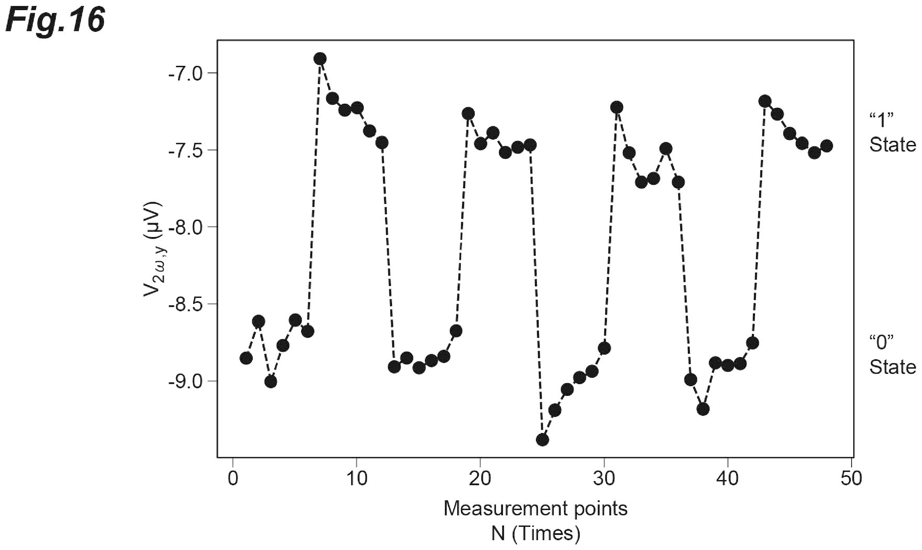

FIG. 16 is a graph showing results of measuring the nonlinear voltage of LuFe₂O₄ by the lock-in method. The horizontal axis shows the measurement point N (number of times), and the vertical axis shows the y component V_{2ω,y} of the second harmonic lock-in voltage. As shown in FIG. 16, it was confirmed that the nonlinear voltage signal takes binary values of "0" and "1" depending on the direction of the pulsed current for writing. It can be said that the graph of FIG. 16 is a result of binarizing the nonlinear voltage. In addition, it was confirmed that data is retained even after 45 seconds or more have elapsed after data writing.

### (Example)

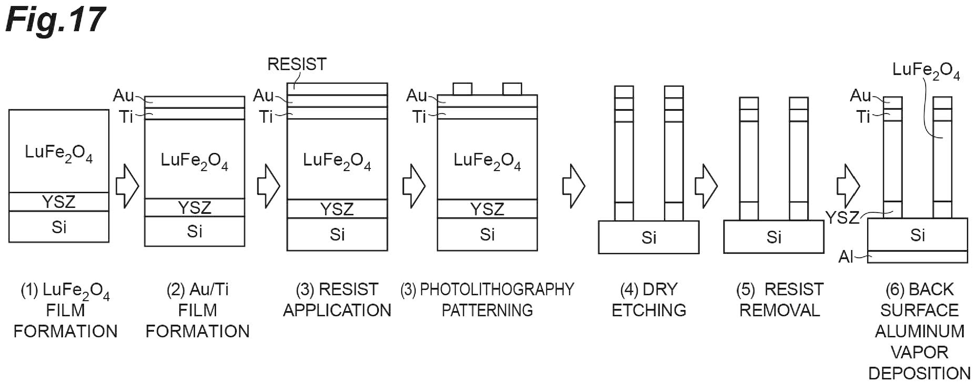

A method for manufacturing an element according to an example will be described with reference to FIG. 17. FIG. 17 is a process flow showing the method for manufacturing an element according to the example. The method for manufacturing an element includes a method for forming a LuFe₂Oₓ film. Hereinafter, formation of a LuFe₂Oₓ film and evaluation of the LuFe₂Oₓ film will be described, and then a method for manufacturing the element will be described.

[Film Formation Method] A P-type Si(111) wafer having a resistivity of 0.1 Ωcm or less was prepared. For the purpose of removing a natural oxide film on the substrate surface, etching treatment was performed by immersion in a hydrofluoric acid aqueous solution (1%).

The substrate from which the oxide film on the surface had been removed was introduced into a pulsed laser deposition (Pulsed Laser Deposition: PLD) film formation apparatus chamber, and a YSZ (1.5% yttrium-doped zirconia) film was formed using YSZ as a target. At a substrate temperature of 750°C, a 5 nm YSZ film in the initial stage of film formation was formed in a vacuum having a vacuum degree of 10⁻⁶ Torr or less, and then a 15 nm YSZ film was formed in an oxygen atmosphere of 4×10⁻⁴ Torr. Furthermore, using a LuFe₂Oₓ target, 150 nm of LuFe₂O₄ was deposited in a vacuum having a vacuum degree of 10⁻⁶ Torr or less at a substrate temperature of 900°C.

A PLD apparatus manufactured by Pascal Corporation was used as the film formation apparatus, and a COHERENT COMPex pro 110 excimer laser (oscillation wavelength 248 nm) was used as a laser source. The laser oscillation intensity was set to 200 mJ, and the laser irradiation diameter on the target was 0.1 cm².

For evaluation of the crystallinity of the film, RHEED (Reflection High Energy Electron Diffraction: RHEED) attached to the PLD apparatus and X-ray diffraction (SmartLab manufactured by Rigaku Corporation) were used.

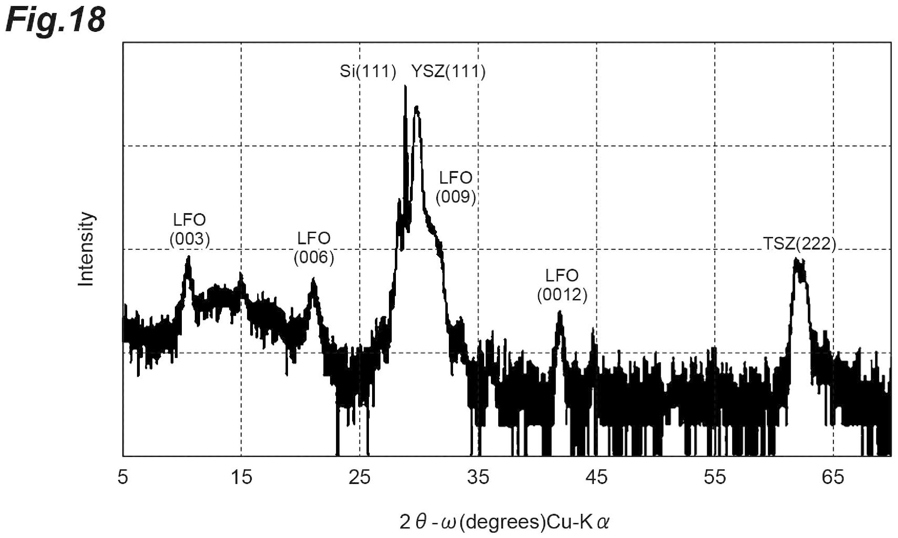

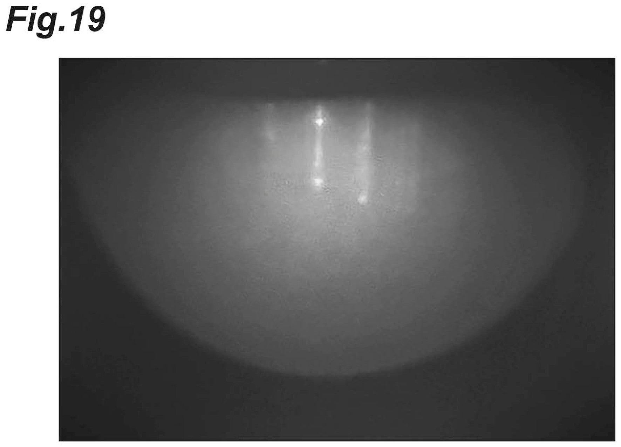

[Evaluation of Film] From the XRD spectrum of the LuFe₂O₄ film grown under the above conditions, it was found that LuFe₂O₄ uniaxially oriented in (001) was formed (see FIG. 18). As the RHEED image of the LuFe₂O₄ film, a single crystal spot pattern with streaks was obtained (see FIG. 19). That is, the LuFe₂O₄ film described in the example is epitaxially formed in the c-axis direction via the YSZ film that has been epitaxially grown in the (111) direction.

[Element Manufacturing Method] Hereinafter, a process for forming an element will be described. Ti and Au are sequentially formed on the surface of the manufactured LuFe2O4 laminated film as an upper electrode. Ti and Au were deposited by a DC sputtering method using a Ti metal target and an Au metal target, respectively, in an Ar atmosphere with the substrate temperature at room temperature. The film formation thicknesses were 10 nm for Ti and 50 nm for Au.

In order to make the manufactured sample into a columnar structure, it was processed into a column shape having a diameter of 400 µmφ by a dry etching method using photolithography. Finally, by depositing 100 nm of Al on the back surface of the substrate by a vapor deposition method, an Au/Ti/LuFe₂O₄/YSZ/Si/Al element having the upper electrode as Au/Ti and the lower electrode as Al was manufactured.

### [Supplementary Notes]

[1] A memory including:
   a film including an electronic ferroelectric having a crystal structure in which layers in which electric polarization is generated in a c-axis direction of a crystal are stacked;
   a pair of electrodes provided on the film so as to be separated from each other in the c-axis direction; and
   at least one current source for applying a current between the pair of electrodes.
[2] The memory according to [1], wherein the current source includes a pulsed current source for applying a pulsed current used for data writing, and an alternating current source for applying an alternating current used for data reading.
[3] The memory according to [1] or [2], further including a voltage detection unit used for data reading,
   wherein the voltage detection unit detects a voltage between two points separated from each other in the c-axis direction in the film.
[4] The memory according to any one of [1] to [3], wherein the electronic ferroelectric is a compound having a layered triangular lattice structure represented by the general formula (RMbO_{3-δ})ₙ(MaO)ₘ, or a compound in which a part of R is substituted with an element having a positive divalent valence or less, where:
   R is at least one element selected from Sc, Y, Dy, Ho, Er, Tm, Yb, Lu, Ca, and Ce;
   Ma and Mb are at least one element selected from Ti, Mn, Fe, Co, Cu, Ga, Zn, Al, Mg, and Cd, allowing duplication;
   n is an integer of 1 or more;
   m is an integer of 0 or more; and
   δ is a real number of 0 or more and 0.2 or less.
[5] A storage device including at least one of the memory according to any one of [1] to [4].
[6] A method for driving a memory including a film including an electronic ferroelectric having a crystal structure in which layers in which electric polarization is generated in a c-axis direction of a crystal are stacked, the method including:
   a step of writing data to the film by applying a pulsed current parallel to the c-axis direction to the film.
[7] The method for driving a memory according to [6], further including a step of reading data from the film by detecting a voltage between two points separated from each other in the c-axis direction while applying an alternating current parallel to the c-axis direction in the film.
[8] A current-driven memory including:
   a film including an electronic ferroelectric having a crystal structure in which layers in which electric polarization is generated in a c-axis direction of a crystal are stacked; and
   electrodes provided on the film.
[9] A nonlinear voltage state control method for controlling a charge ordering structure in a W layer of a compound having a layered triangular lattice structure containing a rare earth element by a current applied from the outside to generate different nonlinear voltage states.
[10] A nonlinear voltage state generating structure capable of generating different nonlinear voltage states by controlling a charge ordering structure in a W layer of a compound having a layered triangular lattice structure containing a rare earth element by a current applied from the outside.
[11] A pulsed current source for data writing of current-driven memory cells, which is connected to current-driven memory cells of a storage device and generates a pulsed current for inverting ferroelectric polarization of the current-driven memory cells.
[12] A circuit for detecting nonlinear voltage of current-driven memory cells, which is connected to current-driven memory cells of a storage device and detects different nonlinear voltages generated depending on the state of ferroelectric polarization of the current-driven memory.
[13] An input/output method including: a pulsed current output step of outputting a pulsed current for inverting ferroelectric polarization of current-driven memory cells; and a nonlinear voltage input step of inputting different nonlinear voltages generated depending on the state of ferroelectric polarization of the current-driven memory cells.
[14] An input/output device in which an output circuit capable of outputting a pulsed current for inverting ferroelectric polarization of current-driven memory cells and an input circuit capable of inputting different nonlinear voltages generated depending on the state of ferroelectric polarization of the current-driven memory cells are connected to a common wiring. The input/output device may be connected to the current-driven memory cells.
[15] A storage device in which a plurality of memory cells each including a first electrode, a film including an electronic ferroelectric formed on the first electrode, and a second electrode formed on the film are arranged,
   wherein the first electrodes of the plurality of memory cells are a conductive substrate continuous with the plurality of memory cells, and the second electrodes are formed so as to be separated from each other.
[16] A method for controlling a storage device in which a plurality of memory cells each including a first electrode, a film including an electronic ferroelectric formed on the first electrode, and a second electrode formed on the film are arranged,
   wherein the first electrodes of the plurality of memory cells are a conductive substrate continuous with the plurality of memory cells, and the second electrodes are formed so as to be separated from each other,
   wherein individual data is written to the film via the second electrode with the first electrode at a common potential.
[17] A pulsed current output circuit including:
   a pulsed current circuit connected to current-driven memory cells of a storage device and generating a pulsed current for inverting ferroelectric polarization of the current-driven memory cells; and
   an electromagnetic wave shielding means covering at least a part of the pulsed current circuit.

### [Additional Statement]

According to the memory, pulsed current drive method, pulsed current drive structure, current-driven memory, storage device, and memory control circuit of the present disclosure, since power consumption is low and high-speed response is possible, it is possible to contribute to Goal 9 of the Sustainable Development Goals (SDGs) led by the United Nations.
Goal 9: "Build resilient infrastructure, promote inclusive and sustainable industrialization and foster innovation"

### Reference Signs List

1, 1A, 1B, 1C, 1D, 1E, 1F, 1G Memory, 2 Film, 3 First electrode, 4 Second electrode, 5 Current source, 6 Voltage detection unit, 8 Third electrode, 9 Fourth electrode, 10 Storage device, 14 Memory

## Claims

1. A pulsed current drive method for inverting ferroelectric polarization generated by the order and imbalance of ions having different valences by applying a pulsed current.

2. A pulsed current drive structure in which ferroelectric polarization generated by the order and imbalance of ions having different valences is inverted by applying a pulsed current.

3. A current-driven memory comprising:
a pulsed current drive structure in which ferroelectric polarization generated by the order and imbalance of ions having different valences is inverted by applying a pulsed current; and
electrodes provided on the pulsed current drive structure.

4. The current-driven memory according to Claim 3, further comprising at least one current source for applying a current between the electrodes.

5. A storage device comprising:
a memory cell comprising the current-driven memory according to Claim 3 or Claim 4;
an output circuit for outputting a pulsed current for inverting the ferroelectric polarization of the memory cell; and
an input circuit for receiving different nonlinear voltages generated depending on the state of ferroelectric polarization of the memory cell.

6. A memory control circuit for controlling a current-driven memory comprising a pulsed current drive structure in which ferroelectric polarization generated by the order and imbalance of ions having different valences is inverted by applying a pulsed current, and electrodes provided on the pulsed current drive structure, the memory control circuit comprising:
a pulsed current source for applying a pulsed current between the electrodes;
an alternating current source for applying an alternating current between the electrodes;
a voltage detection unit for detecting a voltage between the electrodes; and
a control unit for controlling the pulsed current source to write data to the current-driven memory, and controlling the alternating current source and the voltage detection unit to read data from the current-driven memory.
